# EUROPEAN PATENT APPLICATION

(11) **EP 4 760 864 A1**
(43) Date of publication of application: **17.06.2026**
(21) Application number: 24858125.8
(22) Date of filing: 18.07.2024
(51) Int. Cl.: H01M 10/48, H01M 10/42, H01M 50/519, H01M 50/569

(54) **INTEGRATED BUSBAR ASSEMBLY, TEMPERATURE MEASUREMENT METHOD AND BATTERY MODULE**

(30) Priority: 31.08.2023 CN 202311125261
(71) Applicant: Eve Energy Co., Ltd., Huizhou, Guangdong 516006 (CN)
(72) Inventor: WANG, Lei, Huizhou, Guangdong 516006 (CN); LI, Yanyan, Huizhou, Guangdong 516006 (CN)
(74) Representative: Nederlandsch Octrooibureau
(86) International application number: PCT/CN2024/106130
(87) International publication number: WO 2025/044581

(57) **Abstract**

Provided are a cells contact system, a temperature detection method, and a battery module. The cells contact system includes: a circuit board; a temperature sensor disposed on the circuit board and having a temperature detection surface; an electrical conductor disposed on the circuit board to protrude from the temperature detection surface. The electrical conductor is configured to contact a temperature detection portion of the battery module when the temperature detection surface is close to the temperature detection portion.

## Description

This application claims priority to Chinese Patent Application No. 202311125261.1, filed with the China National Intellectual Property Administration on August 31, 2023, the entire content of which is incorporated herein by reference.

### TECHNICAL FIELD

The present disclosure relates to energy storage technologies, and more particularly to a cells contact system, a temperature detection method, and a battery module.

### BACKGROUND

Generally, in a battery module a temperature sensor may be arranged close to a surface of an aluminum bar or a cell terminal. To ensure that the temperature acquired by the temperature sensor is approximate to the temperature of the surface of the aluminum bar or the cell terminal, the following structure is commonly used: 1) a plastic bracket structure is disposed on a side of the temperature sensor opposite to the aluminum bar to provide a holding force; or 2) the temperature sensor is directly adhered to the surface of the aluminum bar or the cell terminal through structural adhesive.

### SUMMARY

However, during the use of the entire battery pack system, it is impossible to know whether the temperature sensor is close to the surface to be detected. Therefore, it is difficult to determine whether a temperature signal acquired by the temperature sensor can truly reflect the temperature of the surface to be detected.

Some embodiments of the present disclosure provide a cells contact system for a battery module. The battery module includes a control board and has a first surface to be detected. The cells contact system includes: a circuit board configured to be connected with the control board; a temperature sensor disposed on the circuit board and having a temperature detection surface, the temperature sensor being configured to acquire a temperature signal and transmit the temperature signal to the control board through the circuit board; and an electrical conductor disposed on the circuit board to protrude from the temperature detection surface. The electrical conductor is configured to, when the temperature detection surface is close to the first surface of the battery module, contact a temperature detection portion of the battery module to generate an electrical signal to be transmitted to the control board through the circuit board.

Some embodiments of the present disclosure provide a temperature detection method by the above cells contact system. The method includes: obtaining the temperature signal acquired by the temperature sensor; and in response to detecting that the electrical signal exists on the electrical conductor, determining that a temperature detection value corresponding to the temperature signal represents a temperature value of the battery module.

Some embodiments of the present disclosure provide a battery module. The battery module includes: a control board; a plurality of cells each having a first surface to be detected and a temperature detection portion; and the above cells contact system, where the temperature detection surface of the temperature sensor is disposed close to the temperature detection portion of at least one of the cells, and the electrical conductor is configured to, when the temperature detection surface of the temperature sensor is close to the first surface of the at least one of the cells, contact the temperature detection portion of the at least one of the cells to generate the electrical signal.

### BENEFICIAL EFFECT

According to the cell contact system according to an embodiment of the present disclosure, the electrical conductor is provided on the circuit board. The electrical conductor protrudes from the temperature-detecting surface of the temperature sensor. During assembly of the battery module for collecting the temperature of the battery module, the electrical conductor first contacts the temperature-detecting portion, and at this time, the temperature-detecting surface approaches the temperature-detecting portion. When the electrical conductor contacts the temperature-detecting portion, the electrical signal is generated. Under the condition that the control board detects the electrical signal, it is determined that the temperature-detecting value corresponding to the temperature signal is the temperature value of the battery module. However, due to assembly tolerances or operational factors, the electrical conductor may be disconnected from the temperature-detecting portion, in which case the temperature-detecting surface is away from the temperature-detecting portion. When the electrical conductor is disconnected from the temperature-detecting unit, the electric signal disappears, and the control board cannot detect the electric signal. The probability that the temperature-detecting value corresponding to the temperature signal deviates from the temperature value of the battery module increases. Therefore, in the present embodiment of the present disclosure, the authenticity of the temperature-detecting value may be effectively determined, thereby improving the reliability of the battery pipeline system and improving the safety of the battery module.

In the temperature-detecting method according to an embodiment of the present disclosure, by detecting whether the electric signal occurs from the electrical conductor, it is determined whether the temperature-detecting surface approaches the surface to be detected, and then it is determined whether the temperature-detecting value corresponding to the temperature signal is the temperature value of the battery module, so that the reliability of the temperature-detecting value of the battery module may be effectively improved. When the electric signal occurs, the temperature-detecting surface approaches the surface to be detected of the battery module, and then it is determined that the temperature-detecting value corresponding to the temperature signal is the temperature value of the battery module.

In the battery module according to an embodiment of the present disclosure, In this battery module, whether the temperature-detecting value corresponding to the temperature signal detected by the temperature sensor is accurate or not is determined by detecting the electrical signal from the electrical conductor, so that the reliability of the temperature-detecting may be improved, and the safety of the battery module may be improved.

### BRIEF DESCRIPTION OF THE DRAWINGS

FIG. 1 is a schematic diagram of a structure of a cells contact system according to some embodiments of the present disclosure.
FIG. 2 schematically shows a cross-section of the cells contact system taken along line A-A in FIG. 1.
FIG. 3 is an enlarged view of part B in FIG. 2.
FIG. 4 is a schematic block diagram of an auxiliary determination circuit constituted by electrical conductors according to some embodiments of the present disclosure.
FIG. 5 is a schematic flowchart of a temperature detection method according to some embodiments of the present disclosure.
FIG. 6 is a schematic diagram of a structure of a battery module according to some embodiments of the present disclosure.
FIG. 7 is an enlarged view of part C in FIG. 6.

### List of reference signs:

**[Table 1_sm_0001]**

| | | | |
|---|---|---|---|
| 10 | Cell | 141 | Head electrical conductor |
| 20 | Temperature detection portion | 142 | Tail electrical conductor |
| 21 | Bar | 150 | Module connector |
| 22 | Terminal | 160 | Voltage acquisition sheet |
| 110 | Circuit board | 111 | First temperature acquisition circuit |
| 120 | Control board | 112 | Second temperature acquisition circuit |
| 130 | Temperature sensor | 113 | Voltage acquisition circuit |
| 131 | Temperature detection surface | 114 | Auxiliary circuit |
| 132 | Head temperature sensor | 151 | First harness |
| 133 | Tail temperature sensor | 152 | Internal harness |
| 140 | Electrical conductor | 153 | Second harness |

### DETAILED DESCRIPTION

In the description of the present disclosure, it should be noted that unless otherwise clearly defined and limited, the terms "coupled", "connected", and "fixed" should be interpreted broadly. For example, the terms may refer to a fixed connection, a detachable connection, or an integral connection; the terms may also refer to a mechanical connection, an electrical connection, a direct connection, an indirect connection through an intermediary, or an interconnection between two elements or interactive relationship between two elements. Those skilled in the art can understand the specific meanings of the above-mentioned terms in the present disclosure according to circumstances.

In the present disclosure, it should he noted that unless otherwise clearly defined and limited, a first feature "on top of" or "under" a second feature may mean that the first feature directly contacts the second feature, or that the first feature contacts the second feature via an additional feature therebetween instead of directly contacting the second feature. Moreover, the first feature "on", "above", and "over" the second feature may mean that the first feature is right above or obliquely upward above the second feature or mean that the first feature has a horizontal height higher than that of the second feature. The first feature "underneath", "below", and "beneath" the second feature may mean that the first feature is right below or obliquely downward below the second feature or mean that that the horizontal height of the first feature is lower than that of the second feature.

In the description of the present disclosure, it should be understood that orientations or position relationships indicated by the terms "upper", "lower", "left", "right", "front", "rear", or the like are based on orientations or position relationships illustrated in the drawings. The terms are used to facilitate and simplify the description of the present disclosure, rather than indicate or imply that the devices or elements referred to herein are required to have specific orientations or be constructed or operated in the specific orientations. Accordingly, the terms should not be construed as limiting the present disclosure. In addition, the term "first", "second", or the like are used to distinguish in the description and have no special meaning..

With the rapid development of a new energy vehicle, a battery management system has also experienced significant advancements as a core component of the new energy vehicle. The cells contact system (CCS) is an important component for acquiring internal state parameters of the battery module. A temperature parameter is a key parameter requiring rigorous monitoring in battery modules. In the related art, after a temperature sensor is assembled to the battery module, it is difficult to know whether the temperature sensor is close to a surface of a detected object due to the assembly precision and the operational factor, and therefore it is difficult to verify the authenticity of temperature data inside the battery module.

An embodiment of the present disclosure provides a cells contact system configured to monitor a battery module. An electrical conductor 140 is provided on the cells contact system, and the electrical conductor 140 generates an electrical signal when it contacts a temperature detection portion 20 of the battery module. A control board 120 of the battery module may determine, by using the electric signal, that a temperature monitoring value corresponding to a temperature signal acquired by a temperature sensor 130 represents the temperature value of the battery module.

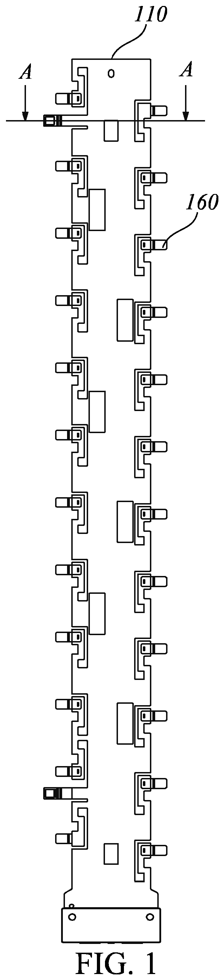

In some embodiments, referring to FIGS. 1 to 4, the cells contact system includes a circuit board 110, the temperature sensor 130, and the electrical conductor 140.

The circuit board 110 is configured to connect the control board 120 of the battery module.

The temperature sensor 130 is disposed on the circuit board 110, the temperature sensor 130 has a temperature detection surface 131, and the temperature signal acquired by the temperature sensor 130 is uploaded to the control board 120 through the circuit board 110.

The electrical conductor 140 is disposed on the circuit board 110 and protrudes from (or protrudes more than) the temperature detection surface 131, the electrical conductor 140 is configured to contact the temperature detection portion 20 to generate the electrical signal when the temperature detection surface 131 is close to (or approaches) a surface to be detected of the battery module, and the electrical signal is uploaded through the circuit board 110 to the control board 120.

In a technical solution of an embodiment of the present disclosure, the electrical conductor 140 is provided on the circuit board 110. The electrical conductor 140 protrudes from the temperature detection surface 131 of the temperature sensor 130. During assembly of the battery module for acquiring the temperature of the battery module, the electrical conductor 140 first contacts the temperature detection portion 20, and at this time, the temperature detection surface 131 is close to the temperature detection portion 20. When the electrical conductor 140 contacts the temperature detection portion 20, the electrical signal is generated. Under the condition that the control board 120 detects the electrical signal, it is determined that the temperature detection value corresponding to the temperature signal represents the temperature value of the battery module. However, due to assembly tolerances or operational factors, the electrical conductor 140 may be disconnected from the temperature detection portion 20, in which case the temperature detection surface 131 is away from the temperature detection portion 20. When the electrical conductor 140 is disconnected from the temperature detection unit 20, the electric signal disappears, and the control board 120 cannot detect the electric signal. The probability that the temperature detection value corresponding to the temperature signal deviates from the temperature value of the battery module increases. Therefore, in the present embodiment of the present disclosure, the authenticity of the temperature detection value may be effectively determined, thereby improving the reliability of the battery pipeline system and improving the safety of the battery module.

In an embodiment, the temperature sensor 130 and the electrical conductor 140 are used in pairs, that is, the temperature sensor 130 acquires the temperature of one of the cells 10 of the battery module, and the electrical conductor 140 is arranged to contact the temperature detection portion 20 of the one of the cells 10.

In an example, the surface to be detected to which the temperature detection surface 131 is close may be a surface of the cell 10, or may be a surface of the bar 21, depending on the implementer's choice.

In some embodiments, the temperature detection portion 20 to be contacted by the electrical conductor 140 may be connected to the input terminal (or output terminal) of the control board 120 via a harness, and the electrical conductor 140 is connected to the output terminal (or input terminal) of the control board 120 via the circuit board 110. After the electrical conductor 140 contacts the temperature detection portion 20, an electric circuit is formed, allowing the control board 120 to detect the electric signal. When the electrical conductor 140 is disconnected from the temperature detection portion 20, the electric circuit breaks, and the control board 120 cannot detect the electric signal.

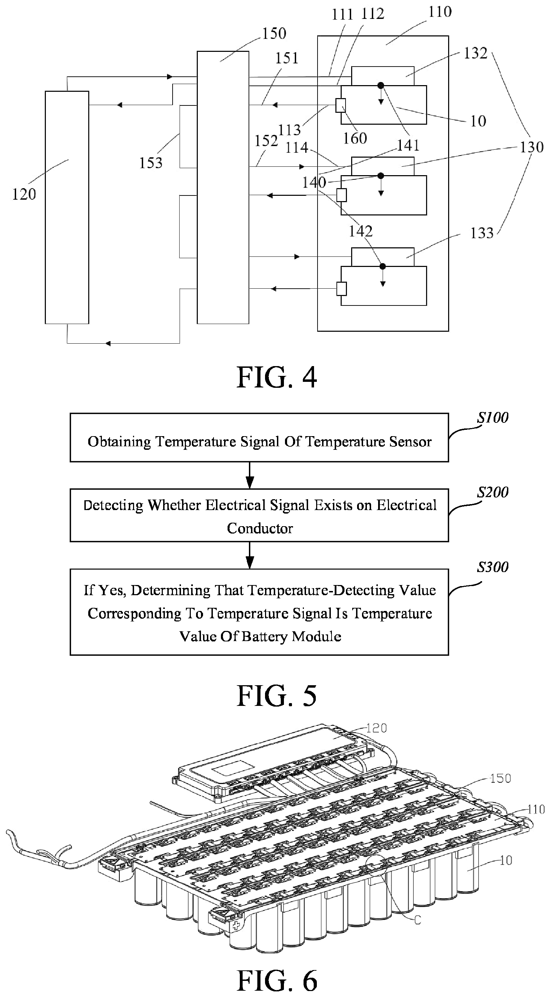

In other embodiments, the electrical conductor 140 forms a circuit connected to the control board 120 by using a portion of a temperature acquisition circuit. Referring to FIG. 4, the circuit board 110 is provided with a first temperature acquisition circuit 111 and a second temperature acquisition circuit 112. The first temperature acquisition circuit 111 is connected to the positive electrode of the temperature sensor 130, and the second temperature acquisition circuit 112 is connected to the negative electrode of the temperature sensor 130. The temperature signal acquired by the temperature sensor 130 is transmitted to the control board 120 through the first temperature acquisition circuit 111 and the second temperature acquisition circuit 112. In an embodiment, the electrical conductor 140 is disposed in any of the first temperature acquisition circuit 111 and the second temperature acquisition circuit 112. That is, the electric circuit for transmitting the electric signal from the electrical conductor 140 may reuse any one of the first temperature acquisition circuit 111 and the second temperature acquisition circuit 112, to reduce the manufacturing process of the circuit board 110.

In an example, the electrical conductor 140 may be a tin block formed by tin plating at the end of the first temperature acquisition circuit 111 or the second temperature acquisition circuit 112, and the tin block protrudes from a temperature detection plane. For example, as shown in FIG. 4, the electrical conductor 140 may be a tin block formed by tin plating on the end of the second temperature acquisition circuit 112. In other example, the electrical conductor 140 may be tin block formed by tin plating on the end of the first temperature acquisition circuit 111. In some embodiments, the electrical conductor 140 may include a conductive metal, such as copper, aluminum, or the like, in addition to a tin block.

In some embodiments, one of the first temperature acquisition circuit 111 and the second temperature acquisition circuit 112 is connected to an input terminal (or output terminal) of the control board 120, and the other one is connected to a temperature acquisition terminal of the control board 120. The temperature detection portion 20 to be contacted by the electrical conductor 140 may be connected to the output terminal (or input terminal) of the control board 120 via the harness.

In other embodiments, the electrical conductor 140 forms a circuit connected to the control panel 120 via a portion of the temperature acquisition circuit and a portion of the voltage acquisition circuit 113. The voltage acquisition circuit 113 is a circuit on the circuit board 110 that transmits a voltage acquired by the cells contact system to the control board 120. As an alternative implementation of the above embodiment, the cells contact system further includes a voltage acquisition sheet 160 disposed on the circuit board 110. The circuit board 110 is further provided with a voltage acquisition circuit 113 connected to the voltage acquisition sheet 160. The voltage acquisition sheet 160 is configured to contact the temperature detection portion 20. In an example, when the voltage acquisition sheet 160 contacts the temperature detection portion 20, under the condition that the electrical conductor 140 contacts the temperature detection portion 20 at the same time, the electrical conductor 140 is electrically connected to the voltage acquisition sheet 160 through the temperature detection portion 20, so that the electrical conductor 140 is electrically connected to the voltage acquisition circuit 113, and the electrical conductor 140 generates the electric signal. That is, the circuit between the electrical conductor 140 and the control board 120 includes a part of the temperature acquisition circuit and a part of the voltage acquisition circuit 113. With this configuration, the manufacturing process of the circuit board 110 may be reduced, and the harness may be reduced, thereby facilitating cost reduction.

In an example, the battery module generally includes the plurality of cells 10, and thus the temperature sensor 130 is provided to include at least two temperature sensors 130. Accordingly, the electrical conductor 140 is also provided to include at least two electrical conductors 140. The electrical conductor 140 includes at least two electrical conductors 140, and each of the at least two temperature sensors 130 is disposed in correspondence with a corresponding one of the at least two electrical conductors 140. After the cells contact system is assembled into a battery module, a temperature sensor 130 and an electrical conductor 140 are arranged in a one-to-one correspondence. Each temperature sensor 130 performs temperature detection for a corresponding one of the cells 10, and the electrical conductor 140 in a one-to-one correspondence with each temperature sensor 130 is configured to contact the corresponding one of the cells 10. In the ideal operation state and in the ideal assembled state, the electrical conductor 140 contacts the temperature detection portion 20 of the cell 10 detected by the temperature sensor 130 in a one-to-one correspondence with the electrical conductor 140.

In an embodiment, the cells contact system further includes a module connector 150. The circuit board 110 is also provided with at least one auxiliary circuit 114. For two adjacent electrical conductors 140, one of the two adjacent electrical conductors 140 is connected to the auxiliary circuit 114 through its corresponding temperature sensor 130, the auxiliary circuit 114 is connected to the voltage acquisition circuit 113, to which the other one of two adjacent electrical conductors 140 is connected, through the module connector 150. In an embodiment, the electrical conductors 140 are connected in series by using the module connector 150 and the voltage acquisition circuit 113. In this embodiment, when one of the electrical conductors 140 is disconnected from the corresponding temperature detection portion 20, the control board 120 cannot detect the electrical signal. With this configuration, the control board 120 can effectively determine whether or not all the temperature sensors 130 effectively are close to the surface to be detected, while the number of external harnesses may be saved.

In other embodiments, each of the electrical conductors 140 may be connected to the control panel 120 through its corresponding voltage acquisition circuit 113. In comparison with the above-described embodiment, when one of the electrical conductors 140 is disconnected from the temperature detection portion 20, the control board 120 may detect an electrical signal of the other one of the electrical conductors 140. In this configuration, the interface of the control board 120 and the external harness need to be added.

In an alternative embodiment, the temperature sensor 130 includes a head temperature sensor 132 and a tail temperature sensor 133, and the electrical conductor 140 includes a head electrical conductor 141 and a tail electrical conductor 142. The head temperature sensor 132 is provided in correspondence with the head electrical conductor 141, and the tail temperature sensor 133 is provided in correspondence with the tail electrical conductor 142. In an example, the temperature detection surface 131 of the head temperature sensor 132 is close to the surface to be detected of a first cell 10 of the cells, and the head electrical conductor 141 is configured to contact the temperature detection portion 20 of the first cell 10. The temperature detection surface 131 of the tail temperature sensor 133 is close to the surface to be detected of a second cell 10 of the cells, and the tail electrical conductor 142 is configured to contact the temperature detection portion 20 of the second cell 10. The head temperature sensor 132 is connected to the output interface (or output terminal) of the control board 120 through the first temperature acquisition circuit 111 and the module connector 150, and the tail electrical conductor 142 is connected to the input interface (or input terminal) of the control board 120 through its corresponding voltage acquisition circuit 113 and the module connector 150. With this arrangement, the head circuit and the tail circuit through which the electrical signal from the electrical conductor 140 is transmitted is connected to the output interface and the input interface of the control board 120, respectively, so that the interfaces of the control board 120 may be reduced.

In an alternative embodiment, as shown in FIG. 4, the cells contact system further includes a first harness 151 and a second harness 152. The module connector 150 includes an internal harness 153. The first harness 151 is connected to the second harness 152 through the internal harness 153. The voltage acquisition circuit 113 is connected to the first harness 151. The auxiliary circuit 114 is connected to the second harness 152. That is, in the embodiment, a portion of the circuit, outside the circuit board 110, for transmitting the electrical signal from the electrical conductor 140 includes the first harness 151, the second harness 152, and the internal harness 153.

As shown in FIG. 4, the temperature sensor includes the head temperature sensor 132, the tail temperature sensor 133, and an intermediate temperature sensor. The head temperature sensor 132 is connected to the output terminal of the control board 120 by using the first temperature acquisition circuit 111 and the module connector 150. The head electrical conductor 141 corresponding to the head temperature sensor 132 is disposed in the second temperature acquisition circuit 112 for the head temperature sensor 132. The circuit board 110 is further provided with a head voltage acquisition sheet and the voltage acquisition circuit 113 corresponding to the head voltage acquisition sheet, and the head voltage acquisition sheet is configured to detect the cell corresponding to the head temperature sensor 132. The voltage acquisition circuit 113 corresponding to the head voltage acquisition sheet is connected to the first temperature acquisition circuit 111 of the intermediate temperature sensor through the corresponding first harness 151, the internal harness 153, the second harness 152, and the auxiliary circuit 114, and the intermediate electrical conductor corresponding to the intermediate temperature sensor is provided on the second temperature acquisition circuit 112 for the intermediate temperature sensor. The circuit board 110 is further provided with an intermediate voltage acquisition sheet and the voltage acquisition circuit113 corresponding to the intermediate voltage acquisition sheet, and the intermediate voltage acquisition sheet is configured to detect the cell 10 corresponding to the intermediate temperature sensor. The voltage acquisition circuit 113 corresponding to the intermediate voltage acquisition sheet is connected to the first temperature acquisition circuit 111 of the tail temperature sensor 133 through the corresponding first harness 151, the internal harness 153, the second harness 152, and the auxiliary circuit 114, and the tail electrical conductor 142 corresponding to the tail temperature sensor 133 is provided on the second temperature acquisition circuit 112 of the tail temperature sensor 133. The circuit board 110 is further provided with a tail voltage acquisition sheet and a voltage acquisition circuit 113 corresponding to the tail voltage acquisition sheet, the tail voltage acquisition sheet is configured to detect the cell 10 corresponding to the tail temperature sensor 133. The voltage acquisition circuit 113 corresponding to the tail voltage acquisition sheet is connected to the input terminal of the control board 120 through the module connector 150.

In this embodiment, when the head electrical conductor 141, the middle electrical conductor and the tail electrical conductor 142 contact the temperature detection portions 20 of their respective cells 10 at the same time, the circuit configured to assist in determining that the temperature detection is turned on, and the control board 120 may detect the electric signal.

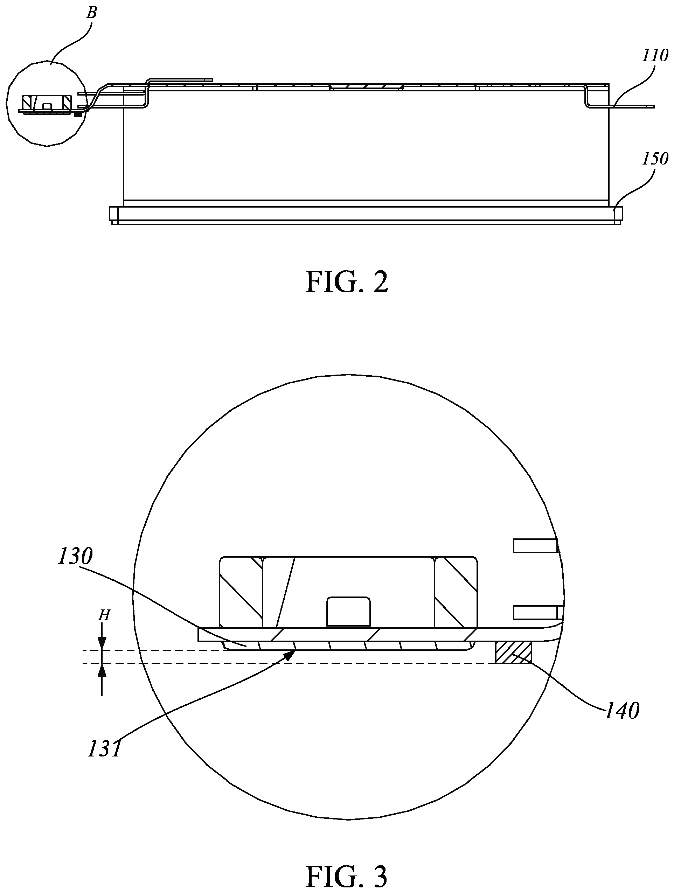

In the above embodiment, as shown in FIG. 3, the electrical conductor 140 protrudes from the temperature detection surface 131 by a distance H, and the value of the distance H satisfies: 0<H≤0.5mm. In the embodiment, the distance by which the electrical conductor 140 protrudes from the temperature detection surface 131 should not be too great, and the distance is limited to less than or equal to 0.5 mm, so as to ensure that an effective distance between the temperature detection surface 131 and the surface to be detected is maintained. In an example, the value of the distance H satisfies: 0.3mm≤H≤0.5mm.

As an alternative embodiment, the temperature sensor 130 is packaged onto the circuit board 110. In an embodiment, the temperature sensor 130 is disposed at the end of the temperature acquisition circuit of the circuit board 110 in the form of a surface-mount technology (SMT) package. There is an NTC thermistor within the temperature sensor 130.

An embodiment of the present disclosure further provides a temperature detection method for the cells contact system as described above. As shown in FIG. 5, the method includes Steps S100, S200, and S300.

At Step S100, a temperature signal of the temperature sensor 130 is obtained.

At Step S200, it is detected whether an electrical signal occurs from the electrical conductor 140.

At Step S300, if Yes, it is determined that the temperature detection value corresponding to the temperature signal represents the temperature value of the battery module.

In the temperature detection method according to an embodiment of the present disclosure, by detecting whether the electric signal occurs from the electrical conductor 140, it is determined whether the temperature detection surface 131 is close to the surface to be detected, and then it is determined whether the temperature detection value corresponding to the temperature signal is the temperature value of the battery module, so that the reliability of the temperature detection value of the battery module may be effectively improved. When the electric signal occurs, the temperature detection surface 131 is close to the surface to be detected of the battery module, and then it is determined that the temperature detection value corresponding to the temperature signal is the temperature value of the battery module.

In an embodiment, as shown in FIG. 5, Step S100 may be performed before Step S200. In some embodiments, Step S100 may be performed after Step S200. In some embodiments, Step S100 and Step S200 may be performed synchronously.

When no electrical signal occurs, the temperature detection surface 131 is away from the surface of the battery module to be detected, and then it is determined that the temperature detection value corresponding to the temperature signal may be different from the actual temperature value of the battery module. In this case, a mark may be made to indicate that there is a deviation in the temperature detection value.

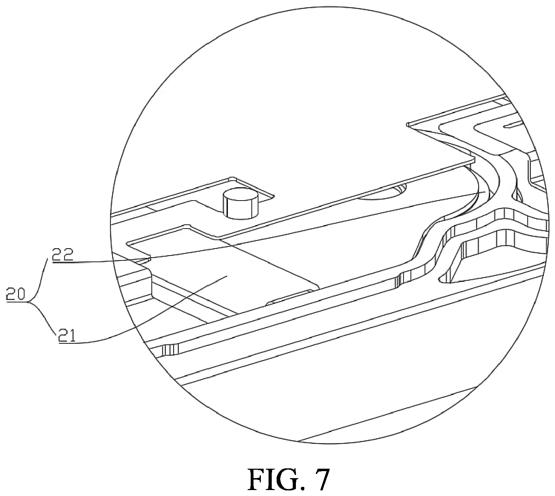

An embodiment of the present disclosure provides a battery module. As shown in FIGS. 6 and 7, the battery module includes a plurality of cells 10 each including a temperature detection portion 20, and a cells contact system. In some embodiments, the cells contact system may be applied by a portion or all of the technical solutions of the foregoing embodiments and thus has a portion or all of the technical advantages of the foregoing embodiments. The temperature detection surface 131 of the temperature sensor 130 is close to the temperature detection portion 20 of at least one of the plurality of cells 10, and the electrical conductor 140 contacts the temperature detection portion 20 of the at least one cell 10 to which the temperature sensor 130 is close.

In this battery module, whether the temperature detection value corresponding to the temperature signal detected by the temperature sensor 130 is accurate or not is determined by detecting the electrical signal from the electrical conductor 140, so that the reliability of the temperature detection may be improved, and the safety of the battery module may be improved.

As an alternative embodiment, the battery module further includes a thermal conductive adhesive, and the temperature detection portion 20 includes a terminal 22 or a bar 21, and the temperature detection surface 131 is connected to the terminal 22 or the bar 21 through the thermal conductive adhesive. In the embodiment, the temperature detection surface 131 is fixed to the bar 21 or the terminal 22 by the thermal conductive adhesive, and the temperature detection is performed by heat conduction.

## Claims

1. A cells contact system, **characterized in that** the cells contact system is configured to monitor a battery module, wherein the battery module comprises a control board, and the cells contact system comprises:
a circuit board configured to be connected with the control board;
at least one temperature sensor disposed on the circuit board, wherein the temperature sensor has a temperature detection surface, and is configured to acquire a temperature signal and transmit the temperature signal to the control board through the circuit board; and
at least one electrical conductor disposed on the circuit board to protrude from the temperature detection surface, wherein the electrical conductor is configured to contact a temperature detection portion[1] of the battery module to generate an electrical signal when the temperature detection surface is close to a surface to be detected of the battery module.

2. The cells contact system of claim 1, wherein a first temperature acquisition circuit and a second temperature acquisition circuit are disposed on the circuit board;
the first temperature acquisition circuit is connected to a positive electrode of the temperature sensor, and the second temperature acquisition circuit is connected to a negative electrode of the temperature sensor; and
the electrical conductor disposed in any of the first temperature acquisition circuit and the second temperature acquisition circuit.

3. The cells contact system of claim 2, further comprising at least one voltage acquisition sheet disposed on the circuit board,
wherein at least one voltage acquisition circuit is disposed on the circuit board and connected with the voltage acquisition sheet; and
the voltage acquisition sheet is configured to contact the temperature detection portion, so that the electrical conductor is electrically connected to the voltage acquisition circuit through the voltage acquisition sheet when the voltage acquisition sheet contacts the temperature detection portion.

4. The cells contact system of claim 3, wherein the at least one temperature sensor comprises at least two temperature sensors, the at least one electrical conductor comprises at least two electrical conductors, the at least two temperature sensors are disposed in one-to-one correspondence with the at least two electrical conductors;
the cells contact system further comprises a module connector, and at least one auxiliary circuit is disposed on the circuit board; and
for two adjacent electrical conductors of the at least two electrical conductors, one of the two adjacent electrical conductors is connected to the auxiliary circuit through a corresponding one of the at least two temperature sensors, and the auxiliary circuit is connected, through the module connector, to the voltage acquisition circuit which is to be electrically connected with another one of the two adjacent electrical conductors.

5. The cells contact system of claim 4, wherein the at least two temperature sensors comprise a head temperature sensor and a tail temperature sensor, and the at least two electrical conductors comprise a head electrical conductor and a tail electrical conductor respectively corresponding to the head temperature sensor and the tail temperature sensor; and
wherein the head temperature sensor is connected to an output interface of the control board through the first temperature acquisition circuit and the module connector, and the tail electrical conductor is connected to an input interface of the control board through the voltage acquisition circuit corresponding to the tail electrical conductor and the module connector.

6. The cells contact system of claim 4 or 5, further comprising a first harness and a second harness,
wherein the module connector comprises an internal harness;
the first harness is connected to the second harness through the internal harness; and
the voltage acquisition circuit is connected with the first harness, and the auxiliary circuit is connected with the second harness.

7. The cells contact system of any one of claims 1 to 6, wherein the electrical conductor is configured to protrude from the temperature detection surface by a distance H, and 0<H ≤0.5mm.

8. A temperature detection method by the cells contact system of any one of claims 1 to 7, comprising:
obtaining the temperature signal acquired by the temperature sensor;
detecting whether the electrical signal exists on the electrical conductor; and
if Yes, determining that a temperature detection value corresponding to the temperature signal represents a temperature value of the battery module.

9. A battery module, **characterized in that** the battery module comprises:
a plurality of cells each having a temperature detection portion; and
the cells contact system of any one of claims 1 to 7, wherein the temperature detection surface of the temperature sensor is close to the temperature detection portion of at least one of the plurality of cells, and the electrical conductor is configured to contact the temperature detection portion of the at least one of the plurality of cells to which the temperature sensor is close.

10. The battery module of claim 9, further comprising a thermal conductive adhesive, wherein the temperature detection portion comprises a terminal or a bar, and the temperature detection surface is connected to the terminal or the bar through the thermal conductive adhesive.
